# EUROPEAN PATENT APPLICATION

(11) **EP 3 428 725 A1**
(43) Date of publication of application: **16.01.2019**
(21) Application number: 17181207.6
(22) Date of filing: 13.07.2017
(51) Int. Cl.: G03F 9/00, G01N 23/225, G01R 31/305

(54) **INSPECTION TOOL, LITHOGRAPHIC APPARATUS, LITHOGRAPHIC SYSTEM, INSPECTION METHOD AND DEVICE MANUFACTURING METHOD**

(71) Applicant: ASML Netherlands B.V., 5500 AH Veldhoven (NL)
(72) Inventor: QUINTANILHA, Richard, 5500 AH Veldhoven (NL); KUMAR, Nitish, 5500 AH Veldhoven (NL); AKBULUT, Duygu, 5500 AH Veldhoven (NL)
(74) Representative: Peters, John Antoine

(57) **Abstract**

An inspection tool for inspecting a semiconductor substrate is described, the inspection tool comprising:
- a substrate table configured to hold the substrate;
- an electron beam source configured to project an electron beam onto an area of interest of the substrate;
- a cathode-luminesce detector configured to detect cathodoluminescent light emitted from the area of interest;
- a control unit configured to:
- receive a signal representative of the detected cathodoluminescent light;
- determine, based on the signal, a stress distribution of the area of interest.

## Description

### BACKGROUND

### Field of the Invention

The present invention relates to an inspection tool, a lithographic apparatus, a lithographic system, an inspection method and a method for manufacturing a device.

### Description of the Related Art

A lithographic apparatus is a machine that applies a desired pattern onto a substrate, usually onto a target portion of the substrate. A lithographic apparatus can be used, for example, in the manufacture of integrated circuits (ICs). In such a case, a patterning device, which is alternatively referred to as a mask or a reticle, may be used to generate a circuit pattern to be formed on an individual layer of the IC. This pattern can be transferred onto a target portion (e.g. including part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Conventional lithographic apparatus include so-called steppers, in which each target portion is irradiated by exposing an entire pattern onto the target portion at once, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

The radiation beam as typically applied in lithographic apparatuses may e.g. be a DUV radiation beam (e.g. having a wavelength of 248 nm or 193 nm) or an EUV radiation beam (.e.g. having a wavelength of 11 nm or 13.5 nm).

The manufacturing of an integrated circuit may typically require the stacking of a plurality of layers, whereby the layers need to be accurately aligned. Without such an alignment, a required connection between layers may be flawed, resulting in a malfunctioning of the integrated circuit.

Typically, the bottom layer or layers of the integrated circuit will contain the smallest structures, such as transistors or components thereof. The structures of subsequent layers are typically larger and enable connections of the structures in the bottom layers to the outside world. In view of this, an alignment of two layers will be the most challenging in the bottom portion of the integrated circuit.

In order to realize such an alignment, use it typically made of a plurality of alignment marks that are provided on the substrate, the position of the alignment marks being indicative of the position of the patterned structures. Due to various process steps that are performed between the exposure processes of two consecutive layers, it may be cumbersome to determine an actual position of the alignment marks. In particular, processing steps such as CMP may result in a deformation of the alignment marks. As a result, the determination of the actual position of the alignment marks may be flawed, resulting in an erroneous or inaccurate assessment of the position of the patterned structures.

It would be beneficial to obtain more reliable information on the position of alignment marks or patterned structures on a substrate, in order to facilitate an alignment of a subsequent layer to the patterned structures.

### SUMMARY

It is desirable to enable a more accurate assessment of a position of structures of a patterned layer on a substrate, in order to facilitate an exposure process of a subsequent patterned layer.

According to an embodiment of the present invention, there is provided an inspection tool for inspecting a semiconductor substrate, the inspection tool comprising
- a substrate table configured to hold the substrate;
- an electron beam source configured to project an electron beam onto an area of interest of the substrate;
- a cathode-luminesce detector configured to detect cathodoluminescent light emitted from the area of interest;
- a control unit configured to:
   - receive a signal representative of the detected cathodoluminescent light;
   - determine, based on the signal, a stress distribution of the area of interest.

According to an embodiment of the invention, there is provided a lithographic apparatus comprising:
- an illumination system configured to condition a radiation beam;
- a support constructed to support a patterning device, the patterning device being capable of imparting the radiation beam with a pattern in its cross-section to form a patterned radiation beam;
- a projection system configured to project the patterned radiation beam onto a target portion of a substrate;
wherein the apparatus further comprises an inspection tool according to the present invention and a stage apparatus configured to position the substrate table so as to impart the substrate with the patterned radiation beam.

According to an embodiment of the invention, there is provided a lithographic system comprising:
- a lithographic apparatus comprising:
   - an illumination system configured to condition a radiation beam;
   - a support constructed to support a patterning device, the patterning device being capable of imparting the radiation beam with a pattern in its cross-section to form a patterned radiation beam;
   - a projection system configured to project the patterned radiation beam onto a target portion of a substrate;
   - a stage apparatus configured to position the substrate table so as to impart the substrate with the patterned radiation beam;
- an inspection tool according to the present invention.

According to an embodiment of the invention, there is provided an inspection method, the method comprising the steps of:
- providing a semiconductor substrate with an area of interest, the area of interest comprising a structure;
- scanning the area of interest using an electron beam;
- capturing cathodoluminescent light emitted from the area of interest;
- determining a stress distribution of the area of interest.

According to an embodiment of the invention, there is provided a device manufacturing method comprising projecting a patterned beam of radiation onto a substrate, wherein the step of projecting the patterned beam of radiation onto the substrate is preceded by the inspection method according to the present invention.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention;
Figure 2 depicts an inspection tool according to an embodiment of the invention;
Figure 3 depicts a frequency spectrum of CL-light as can be determined by an inspection tool according to the present invention;
Figure 4 schematically depicts a cross-sectional view of a structure that can be examined using an inspection tool according to the present invention;
Figure 5 schematically depicts a cross-sectional view of a deformed alignment mark that can be examined using an inspection tool according to the present invention;
Figure 6 schematically depicts a possible effect of mechanical stress on a frequency spectrum of CL-light.

### DETAILED DESCRIPTION

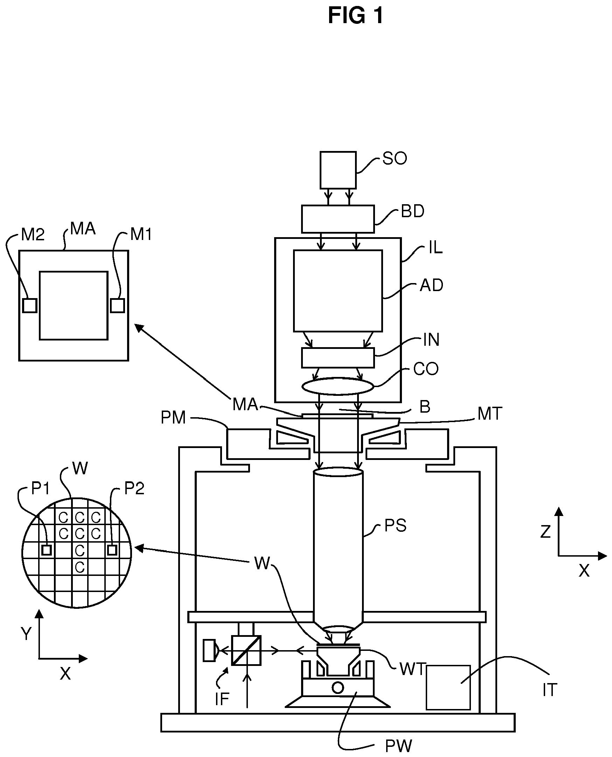

Figure 1 schematically depicts a lithographic apparatus according to one embodiment of the invention. The apparatus includes an illumination system (illuminator) IL configured to condition a radiation beam B (e.g. UV radiation or any other suitable radiation), a mask support structure (e.g. a mask table) MT constructed to support a patterning device (e.g. a mask) MA and connected to a first positioning device PM configured to accurately position the patterning device in accordance with certain parameters. The apparatus also includes a substrate table (e.g. a wafer table) WT or "substrate support" constructed to hold a substrate (e.g. a resist-coated wafer) W and connected to a second positioning device PW configured to accurately position the substrate in accordance with certain parameters. The apparatus further includes a projection system (e.g. a refractive projection lens system) PS configured to project a pattern imparted to the radiation beam B by patterning device MA onto a target portion C (e.g. including one or more dies) of the substrate W.

The illumination system may include various types of optical components, such as refractive, reflective, magnetic, electromagnetic, electrostatic or other types of optical components, or any combination thereof, for directing, shaping, or controlling radiation.

The mask support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The mask support structure can use mechanical, vacuum, electrostatic or other clamping techniques to hold the patterning device. The mask support structure may be a frame or a table, for example, which may be fixed or movable as required. The mask support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section so as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask)

The lithographic apparatus may be of a type having two (dual stage) or more substrate tables or "substrate supports" (and/or two or more mask tables or "mask supports"). In such "multiple stage" machines the additional tables or supports may be used in parallel, or preparatory steps may be carried out on one or more tables or supports while one or more other tables or supports are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques can be used to increase the numerical aperture of projection systems. The term "immersion" as used herein does not mean that a structure, such as a substrate, must be submerged in liquid, but rather only means that a liquid is located between the projection system and the substrate during exposure.

Referring to figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD configured to adjust the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the mask support structure (e.g., mask table MT), and is patterned by the patterning device. Having traversed the mask MA, the radiation beam B passes through the projection system PS, which focuses the beam onto a target portion C of the substrate W. With the aid of the second positioning device PW and position sensor IF (e.g. an interferometric device, linear encoder or capacitive sensor), the substrate table WT can be moved accurately, e.g. so as to position different target portions C in the path of the radiation beam B. Similarly, the first positioning device PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioning device PM. Similarly, movement of the substrate table WT or "substrate support" may be realized using a long-stroke module and a short-stroke module, which form part of the second positioning device PW. In the case of a stepper (as opposed to a scanner) the mask table MT may be connected to a short-stroke actuator only, or may be fixed. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT or "mask support" and the substrate table WT or "substrate support" are kept essentially stationary, while an entire pattern imparted to the radiation beam is projected onto a target portion C at one time (i.e. a single static exposure). The substrate table WT or "substrate support" is then shifted in the X and/or Y direction so that a different target portion C can be exposed. In step mode, the maximum size of the exposure field limits the size of the target portion C imaged in a single static exposure.
2. In scan mode, the mask table MT or "mask support" and the substrate table WT or "substrate support" are scanned synchronously while a pattern imparted to the radiation beam is projected onto a target portion C (i.e. a single dynamic exposure). The velocity and direction of the substrate table WT or "substrate support" relative to the mask table MT or "mask support" may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT or "mask support" is kept essentially stationary holding a programmable patterning device, and the substrate table WT or "substrate support" is moved or scanned while a pattern imparted to the radiation beam is projected onto a target portion C. In this mode, generally a pulsed radiation source is employed and the programmable patterning device is updated as required after each movement of the substrate table WT or "substrate support" or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

In the embodiment as shown, the lithographic apparatus further comprises an inspection tool IT according to the invention. Such an inspection tool IT may e.g. enable to determine a deformation of an area of interest of a substrate W that is processed by the lithographic apparatus. In an embodiment, as will be discussed in more detail below, the inspection tool may comprise an electron beam source for inspecting the substrate.

In an embodiment, the second positioning device PW may be configured to position the substrate W in the operating range of the inspection tool IT. In such an embodiment, the inspection tool IT may e.g. be configured to determine a deformation or displacement of markings, such as alignment marks, on the substrate. This deformation data may subsequently be used during the exposure process, in order to accurately align the substrate W with the patterned radiation beam.

In the embodiment as shown, the lithographic apparatus may be configured to apply DUV radiation for the radiation beam. In such case, the patterning device MA may be a transmissive patterning device and the projection system PS may comprise one or more lenses.

Alternatively, the lithographic apparatus according to the present invention may be configured to apply EUV radiation for the radiation beam. In such case, the patterning device MA may be a reflective patterning device and the projection system PS may comprise one or more mirrors. In such embodiment, the apparatus may comprise one or more vacuum chambers for housing the illumination system IL and/or the projection system PS.

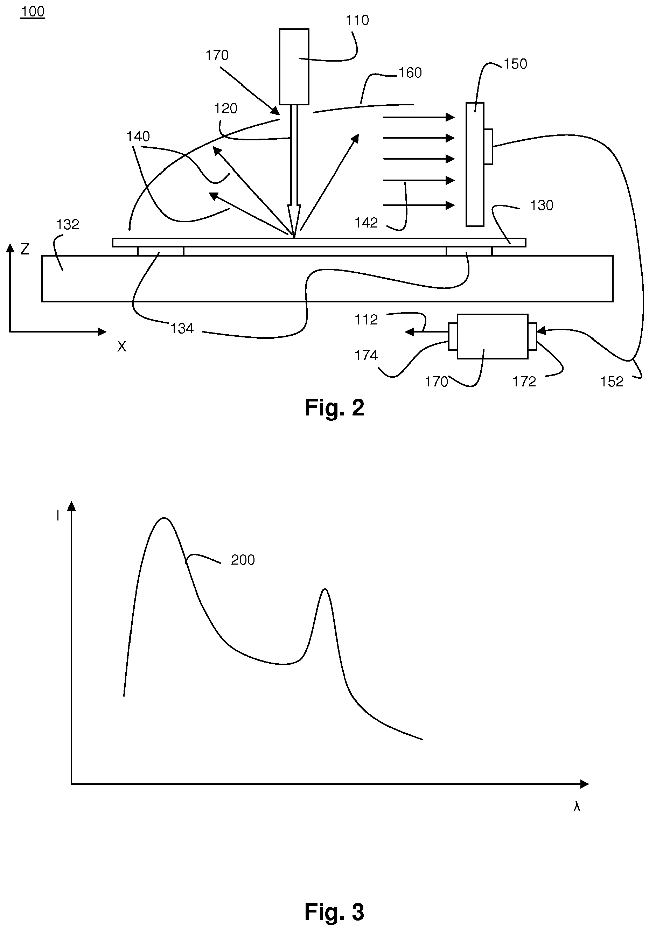

According to an aspect of the invention, there is provided an inspection tool configured to inspect an object such as a substrate. Figure 2 schematically shows an embodiment of such an inspection tool 100. In accordance with the present invention, the inspection tool 100 comprises an electron beam source 110, further on also referred to as an e-beam source 110.
Such an e-beam source 110 is known in general, and may be applied in the present invention to project an electron beam 120 onto an area of an object 130, e.g. a substrate. In the embodiment as shown, the object 130 is mounted to an object table 132 by means of a clamping mechanism 134, e.g. a vacuum clamp or an electrostatic clamp. The area of the object onto which the e-beam is projected may also be referred to as sample. Such an e-beam source 110 may e.g. be used to generate an electron beam 120 having an energy ranging from 0.2 keV to 100 keV. An e-beam source 110 may typically have one or more lenses for focusing the electron beam 120onto a spot of about 0.4 to 5 nm in diameter. In an embodiment, the e-beam source 110 may further comprise one or more scanning coils or deflector plates which may deflect the electron beam 120. By doing so, the electron beam 120 may e.g. be deflected along an X-axis and an Y-axis (perpendicular to the X-axis and the Z-axis), the XY-plane being parallel to a surface of the object, such that an area of the object can be scanned.
In an embodiment of the present invention, the electron beam source is configured to project a plurality of electron beams onto a respective plurality of sub-areas of the area of interest. By doing so, the area of interest that can be examined or inspected per unit of time may be enlarged. Further, in an embodiment of the present invention, the electron beam source may be configured to generate electron beams having a different energy level. As will be explained in more detail below, depending on the applied energy level for the e-beam or beams, different portions or a structure, e.g. a buried structure, may be examined.

When such an e-beam 120 impinges on the surface, interactions on the surface and interactions with the material below the surface will occur, resulting in the exposed surface emitting both radiation and electrons. Typically, when an electron beam 120 interacts with a sample, the electrons constituting the beam will loose energy through scattering and absorption, within a teardrop-shaped volume, known as the interaction volume. The energy exchange between the electron beam and the sample will typically result in a combination of:
- the reflection of high energy electrons by elastic scattering,
- an emission of secondary electrons by inelastic scattering,
- an emission of electrons that are reflected or back-scattered out of the interaction volume by elastic scattering interactions with the sample,
- X-ray emission, and
- an emission of electromagnetic radiation, e.g. in a range from deep UV to IR.
The latter emission of electromagnetic radiation is generally referred to as cathodoluminescent light or CL-light. In Figure 2, the arrows 140 are indicative for the emitted cathodoluminescent light.
In an embodiment of the present invention, the inspection tool 100 further comprises a detector 150 for detection such cathodoluminescent light 140 emitted by a sample. In the embodiment as shown, the inspection tool 100 comprises a reflector 160, e.g. an elliptical or parabolic reflector to redirect the CL-light 140 towards the detector 150, as indicated by the arrows 142. In the embodiment as shown, the reflector 160 is provided with an aperture 170, through which the e-beam 120 can be directed towards the object 130.

The detector 150 as applied in the inspection tool 100 according to the present invention may e.g. be formed as a CCD array, e.g. a two-dimensional CCD array, a hyperspectral sensor or a spectrograph. In an embodiment of the present invention, the inspection tool further comprises a control unit 170 or processing unit, e.g. comprising a microprocessor, computer or the like, for processing the CL-light 140, 142 as detected by the detector 150. In an embodiment, the control unit 170 comprises an input terminal 172 for receiving a signal 152 from the detector 150, the signal 152 representing the detected CL-light 142 emitted by the object 130.
In an embodiment, the control unit may further have an output terminal 174 for outputting a control signal 112 for controlling the e-beam source 110. In an embodiment, the control unit 170 may control the e-beam source 110 to project an e-beam 120 onto an area of interest of the object to be inspected, e.g. a semiconductor substrate.
In an embodiment, the control unit 170 may be configured to control the e-beam source 110 to scan the area of interest.

During such scanning of an area of interest of an object, the detector may receive CL-light 142 from different portions of the area of interest. As an example, the applied e-beam may e.g. have a cross-section of 1 - 4 nm in diameter, while the area of interest is 100 nm x 100 nm. As such, when the area of interest has been scanned, a response to the e-beam across the area of interest may have been captured by the CL-light detector 150.

In an embodiment, the control unit 170 as applied in the inspection tool 100 according to the present invention may be configured to determine a frequency spectrum of the CL-light as received by the detector 150.

Figure 3 schematically shows a frequency spectrum 200, indicating the intensity I of the received CL-light as a function of the wavelength λ.
In general, the frequency spectrum of the received CL-light may depend on various parameters. As will be understood, the frequency spectrum may depend on the material that is probed by the e-beam. In case of a semiconductor substrate, the area of interest that is examined may comprise structures that form part of integrated circuits of semiconductor devices. These structures or devices will typically comprise different materials. Each of these materials may result in the generation of a particular CL-light having a particular frequency spectrum. Since the CL-light is generated in volume underneath the surface of the object, referred to as the interaction volume, the CL-light as received may originate from a combination of different materials, in case the interaction volume would encompass different materials or structures. As will be explained in more detail below, by changing the energy of the e-beam, it is possible to change the volume that is probed and in particular the depth of the probed volume, i.e. the interaction volume, which enables access to buried materials and structures and enables the creating of a 3D mapping.

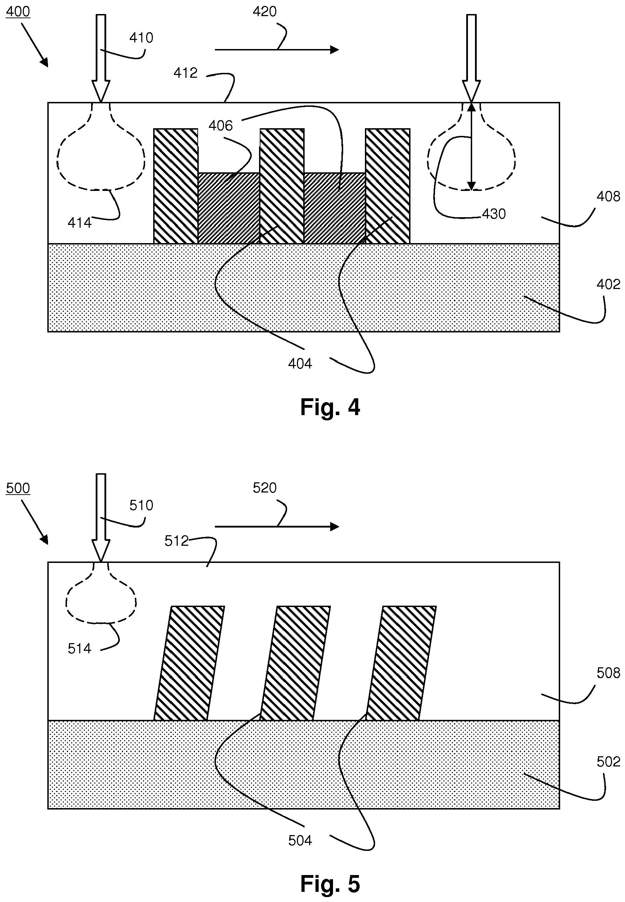

Figure 4 highly schematically shows a cross-sectional view of a semiconductor structure 400 comprising multiple layers and different materials. The structure 400 as schematically shown in Figure 4 comprises a bottom layer 402 of a first material, three vertically extending structures 404 of a second material on top of said bottom layer 402, a gap between adjacent structures 402 being partially filled with structures 406 of a third material and the structures 404 and 406 being covered by a top layer 408 of a fourth material. Figure 4 further schematically shows an e-beam 410 impinging on the top surface 412 of the structure 400. Indicated by the dotted line 414 is the interaction volume of the e-beam 410, i.e. the volume where CL-light may be generated as a result of the applied e-beam. It can be noted that, while the e-beam may have a diameter of only a few nm, the interaction volume will typically have a larger diameter, e.g. 10-20 nm. Figure 4 further illustrates the scanning of the e-beam (indicated by arrow 420) towards the right, thereby moving the interaction volume 414 across the structures 404 and 406. During said scanning, the interaction volume 414 will encompass the various materials of the structures. As such, during such scanning movement, variations in the frequency spectrum of the CL-light will occur; based on these variations, one may thus deduce that different materials or structures are present underneath the surface 412. In this respect it can be noted that the CL-light as generated is typically strongly material dependent.

With respect to the interaction volume 414 as schematically indicated in Figure 4, it is further worth mentioning that the height or depth 430 of the interaction volume 414 will depend, among others, on the energy level of the applied e-beam 410. As will be understood by the skilled person, the e-beam 410 will not be able to penetrate deep into the structure 400 in case the energy level of the electrons is comparatively low. In such case, the interactions may be limited to interactions with the material at or near the surface 412, i.e. material 408.

When the surface 412 is scanned with an e-beam 410 having a comparatively high energy level, the interaction volume will extend deeper into the structure 400, resulting in the detection of the different materials and structures, based on the observed variations in the CL-light spectra observed during the scan.
As such, by scanning the area of interest with e-beams of different intensity or energy levels, insight can be gained on the location of various structures and/or on the thickness of different layers of materials.

As mentioned, the CL-light as generated due to the interaction of an e-beam impinging on an area of interest will vary, depending on the material or structure encountered. In addition, it has been observed that the CL-light as emitted by an object or structure in response to the application of an e-beam may vary when the object or structure is subjected to stress.

In the present invention, use is made of this characteristic. In particular, in the present invention, the CL-light as captured by a detector of the inspection tool is used to determine a stress distribution across the area of interest and underneath the surface of the area of interest. In a similar manner as explained with respect to Figure 4, by scanning an area of interest and observing the CL-light generated, variation in the observed spectrum may be indicative of mechanical stress occurring in the material observed, i.e. the material that is present in the interaction volume. In the present invention, this phenomenon will be used to derive a deformation of the object or structure that is inspected, in particular a semiconductor structure on a substrate. In accordance with an embodiment of the present invention, the CL-light as detected may be used to determine an occurring stress or stress distribution in a volume located underneath a surface of the area of interest. As indicated above, by adjusting the energy of the applied e-beam, the volume underneath the surface of the area of interest that is probed, i.e. the interaction volume where the CL-light is generated, may be adjusted. In particular, using a comparatively low energy e-beam will result in CL-light being generated at or near the surface of the area of interest, whereas the application of a comparatively high energy e-beam will result in CL-light being generated in a volume below the surface of the area of interest, i.e. the interaction volume. As such, by scanning the area of interest using e-beams having different energy levels, insight can be gained on the stress or stress distribution underneath the surface of the area of interest, e.g. in a volume where semiconductor structures may be present.

During the manufacturing process of semiconductor devices, the substrate as a whole, or the structures on the substrate may be subjected to stress due to the various processes to which the substrate is subjected.

In order to manufacture a semiconductor device, e.g. a microprocessor or a memory chip, a semiconductor substrate is subjected to various processes, including lithographic exposure processes to pattern resist layers, thermal processes, coating processes, chemical-mechanical processes such as CMP (chemical-mechanical planarization). Such processes may introduce stresses in the substrate or structures on the substrate.

Further, stresses may be introduced in the substrate due to the application of multiple layers. As an example of such a multilayer application, 3D NAND devices may e.g. be mentioned. The large number of layers applied in such devices, e.g. up to 128, may lead to a large stress in the substrate. As an indication of such stress, a height difference between center and edge of a substrate may be mentioned. Due to this stress, the height difference observed between the center and the edge of substrate, when held in a relaxed state, may e.g. be about 300 µm. This height difference may e.g. complicate the clamping of the substrate and result, after clamping, in a significant stress in the substrate.

When stresses occur in a material, the electronic band structure, or band structure of the material changes and consequently its cathodoluminescent spectrum. As such, in case an area of interest is scanned with an electron beam, and the CL-light as emitted is detected and e.g. recorded, variation in the spectrum of the CL-light may be noticed.

In an embodiment of the present invention, the inspection tool according to the present invention is used to examine one or more alignment marks on a substrate. In particular, the inspection tool according to the present invention may be used to assess a deformation of such an alignment mark.

Figure 5 highly schematically depicts a cross-sectional view on an area of interest 500 comprising an alignment mark 504 which is deformed, e.g. due to a processing. In the embodiment as shown, the alignment mark 504 comprises three vertically extending structures 504 which top size has been bend to the right, relative to the bottom size. Such a deformation may e.g. be caused by an CMP process or by the application of multilayer structures. In the embodiment as shown, the alignment mark is positioned on a bottom layer 502 of a different material and the alignment mark is covered by yet another material 508. Due to the difference in material between the alignment mark and the enclosing layer 508, e.g. a resist layer, stresses may be build up, either in the surrounding layer 508, in the alignment mark 504, or both.

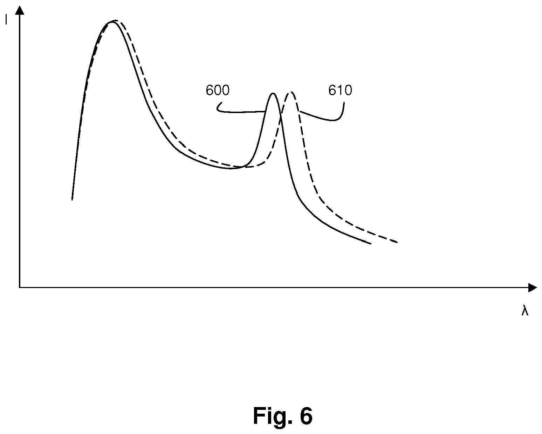

Such stresses may result in a change in the frequency spectrum of the CL-light generated in the particular materials. Figure 6 schematically shows a frequency spectrum of CL-light for a particular material in a nominal condition (curve 600) and when subjected to a certain stress level (curve 610). In the embodiment as shown, the stress induced a shift in the spectrum. As such, when the surface area 512 of the area of interest 500 is scanned using an e-beam 510 in a direction 520, shifts or, in general, variations in the frequency spectrum of the CL-light may be observed, whereby said variations may be associated with certain stress levels in the material.

By means of experimenting, the effect of a certain amount of stress on the CL-spectrum emitted, may be determined for various types of materials, and e.g. stored in a database. In an embodiment of the present invention, the control unit of the inspection tool, e.g. control unit 170 shown in Figure 2, may be connected or connectable to such a database. It may further be pointed out that such a data base may further be useful to distinguish between variations in the frequency spectrum that are caused by stress and variations that are caused by transitions from one material or structure to another, or other sources of stress, as discussed with reference to Figure 4.

With respect to the latter distinction, it may also be pointed out that information on the geometry of the structure may also be found useful in distinguishing whether or not an observed variation of the frequency spectrum is caused by stresses in the material or by a transition to another material.

It may further be pointed out that in case substantial changes are observed in the spectrum, e.g. intensity peaks disappearing or appearing, it is highly likely that the transition observed is not caused by local stresses in the material.

In the above, it has been discussed that variations in the CL-light, in particular variations in the frequency spectrum of the captured CL-light may be used to identify variations in materials, and stresses occurring in materials or structures. In this respect, it is worth pointing out that other characteristics of the CL-light, apart from the spectrum may be used as well to assess a state of the substrate or inspect the substrate. In addition to, or as an alternative to observing the frequency spectrum of the received CL-light, other characteristics of the received CL-light may be considered as well in order to assess transitions between structures or materials or to assess an occurrence of stress. Examples of such other characteristics may e.g. be a polarization characteristic of the CL-light, an orientation of the received CL-light or a transient characteristic of the CL-light. In a similar manner as the assessment of the frequency spectrum of the CL-light and its variation across an area of interest, so can an assessment of a polarization characteristic of the received CL-light be use to determine the occurrence of variations in material properties, including stress. Similarly, the orientation, in particular the angular orientation of the received CL-light may also be used to assess transitions between structures or materials or to characterize such structures or materials. Note that the angular orientation of the CL-light may e.g. be determined or characterized by the position at which the light impinges on the detector. With reference to Figure 2, it will be clear to the skilled person that the angular orientation of the CL-light, indicated by the arrows 140, affects the position at which the light impinges on the reflector 160 and thus also affect the position, at which the CL-light impinges the detector 150. Yet another characteristic of the CL-light is any transient, i.e. any variation over time, that may be perceived in the captured light.

Further, with reference to Figure 5, it may be pointed out that by ensuring that the depth of the interaction volume 514 is comparatively small, the interaction volume 514 will only interact with the material 508. In such case, any variations in the spectrum can be attributed to stress in the material 508.

In an embodiment of the present invention, the stress distribution as determined, i.e. based on variations observed in the detected CL-light across the area of interest, is used to determine or estimate the deformation of the structure that is present, e.g. buried, in the area of interest.

In an embodiment of the present invention, a mechanical model of the area of interest may be used to determine, based on the stress distribution, the deformation of the structure. Such a mechanical model may e.g. comprise various mechanical parameters of the materials applied in the structure, e.g. combined with geometric data of the structure. As an example of such mechanical model, a finite element model can be mentioned. In such a model, the stress or stress distribution as determined can be used as input, whereas the deformation or an estimation of the deformation may be obtained as output.

In case the structure that is inspected comprises an alignment mark, the information on the deformation as obtained may be provided to a lithographic apparatus that is to process the substrate with the alignment mark.

Typically, prior to exposing a substrate with a new patterned radiation beam, the position of the target portions need to be determined accurately, in order to ensure a proper alignment between the new pattern and any patterns already present on the substrate. In order to determine the positions of the target portions, an alignment sensor may be used. By means of such a sensor, a beam of radiation may be projected onto the alignment mark (such as mark 504 shown in Figure 5), and radiation reflected is captured and analyzed, thus determining the position of the alignment mark. In general, this process is repeated for a plurality of alignment marks that are distributed across the substrate. Based on the determined positions of the alignment marks, one may then determine the positions of the target portions, e.g. target portions C as discussed with reference to Figure 1.

As will be clear from the above, the positioning of the substrate relative to the patterned radiation beam strongly relies on the accuracy at which the position of the alignment marks may be determined. In this respect, it is worth mentioning that the accuracy of the alignment mark position measurement by the alignment sensor is affected by a deformation of the alignment mark. Phrased differently, an alignment sensor attempting to determine a position of a deformed alignment mark, may provide an erroneous position of the alignment mark.

By means of the inspection tool according to the present invention, this effect can be mitigated. In particular, in case the deformation of the alignment mark is know, the effect of the deformation on the position measurement by the alignment sensor can be taken into account and compensated for. As such, in an embodiment of the present invention, the inspection tool is used to determine a substrate deformation map. Such a substrate deformation map may e.g. be expressed as a two-dimensional function expressing a deformation of the substrate in a substrate coordinate system.

In order to determine such a substrate deformation map, or function, the above described process of assessing a deformation of a structure of an area of interest is repeated at various locations on the substrate. In an embodiment, the process is repeated for a plurality of alignment marks that are present on the substrate. Note however that any other structures on the substrate, e.g. portions of integrated circuits or devices that are patterned, may be used as well to assess a deformation at a particular location on the substrate. Once such a substrate deformation map is established, it may be used to correct alignment measurements made by an alignment sensor. As a result, since a position of the alignment marks may be determined more accurately, a more accurate knowledge of the position of the target portions for the patterned radiation beam is obtained. This positional information may e.g. be used in controller or control unit that control the positioning device that positions the substrate relative to the patterned radiation beam, e.g. positioning device PW shown in Figure 1.

As mentioned, in order to arrive at a proper functioning of the semiconductor device that is manufactured, it is important that consecutive layers that are applied on a substrate are properly aligned. During the manufacturing process, the accuracy of this process may be checked by measuring the overlay between two consecutive layers; overlay being a measure to indicate how accurate two consecutively applied layers are aligned. In order to assess this, dedicated marks may be applied, referred to as overlay marks. An assessment of the overlay, i.e. the accuracy of alignment between two layers may e.g. be done using an overlay sensor, such a sensor being configured to determine a relative position, in the plane of the substrate between a first overlay mark, formed in a first layer, and a second overlay mark, formed in a second, consecutive layer. When such an overlay sensor is used to assess the alignment between two consecutive layers, this overlay data may e.g. be used to adjust an alignment process of further layers.

However, in a similar manner as discussed with respect to the assessment of the position of the alignment marks using an alignment sensor, an overlay measurement performed by an overlay sensor may be affected by a deformation of the overlay mark or marks. As such, due to a deformation of the overlay marks, an erroneous assessment of the overlay between two consecutive layers may be made. In order to mitigate this, a substrate deformation map may be established, as discussed above, and used to correct the overlay measurements.

As described above, the various processes applied to a substrate during the manufacturing of semiconductor devices such as integrated circuits may cause deformations of the structures. Another cause of deformation of a substrate is the clamping process that is applied each time a substrate is transferred into a lithographic apparatus in order to be exposed to a patterned radiation beam. Typically, in order to clamp a substrate to a substrate table, the substrate table is provided with a clamping mechanism such as a vacuum clamp or an electrostatic clamp. Due to the clamping of the substrate onto the substrate table, a deformation of the substrate may occur as well. The aforementioned processes such as thermal processing or CMP, a substrate may deform such that its bottom surface is no longer flat but curved or warped. When such a substrate is clamped, i.e. attracted by a clamping mechanism, it will adhere to the substantially flat surface of the clamp. This process requires the substrate to deform. As will be understood, such a clamping process will thus induce stresses in the substrate. In a similar manner as discussed above, such clamping induced stresses may be detected by assessing variations in the CL-light as emitted during a scanning of an area of interest with an e-beam.
As such, in an embodiment of the present invention, a stress distribution of a substrate is determined, while the substrate is clamped onto a substrate table.
In an embodiment of the present invention, the substrate table that is used during the assessment of the stress distribution by the inspection tool, is also used during a subsequent exposure of the substrate to a patterned radiation beam. As such, in an embodiment, the present invention provides in a lithographic system comprising a lithographic apparatus and an inspection tool, whereby the lithographic apparatus comprises a stage apparatus configured to position the substrate table in an operating range of the e-beam, so as to scan the substrate with an e-beam of the e-beam source for inspection, and in an operating range of the projection system, so as to impart the substrate with the patterned radiation beam generated by the projection system. In such embodiment, the lithographic system may be configured to:
- inspect a substrate, while clamped on a substrate table that is positioned by the stage apparatus of the lithographic apparatus;
- determine a substrate deformation map of the substrate;
- determine a position of the target portions on the substrate by determining a position of alignment marks on the substrate using an alignment sensor, whereby the alignment sensor makes use of the substrate deformation map;
- positioning the substrate, while on the substrate table, by the stage apparatus, in accordance with the determined position of the target portions in order to expose the target portions to the patterned radiation beam.

In the embodiments discussed above, the detected stress in an area of interest was associated with a deformation of a structure, e.g. an alignment mark or an overlay mark or part of a semiconductor device. On a more global level, stresses, e.g. induced in the substrate during clamping, may deform the substrate as a whole. Such a deformation may e.g. results in displacements of marks and devices relative to their nominal or expected positions. Such displacements may also be quantified and described as a substrate grid deformation, grid referring to substrate coordinate system associated with the nominal position of e.g. alignment marks. When alignment marks are displaced, e.g. due to the applied clamping force, relative to their nominal positions, the target portions on the substrate, i.e. the portions were a next exposure is to be applied, will change too.

By means of the inspection tool according to the present invention, a stress distribution across the substrate can be determined and may be applied to determine or estimate a deformation of the substrate grid. Such a substrate grid deformation may subsequently be used during the control of the stage apparatus positioning the substrate table relative to the patterned radiation beam. Note that the transition from a stress distribution across the substrate to a deformation of the substrate may e.g. be realized by means of a mechanical model of the substrate. Alternatively, empirical model, e.g. derived based on experimental data, may be considered as well to arrive at the substrate deformation or substrate grid deformation.

In the embodiment of the lithographic system as discussed above, the inspection tool was incorporated in the lithographic apparatus in such manner that a substrate could maintain clamped onto the same substrate table during both the inspection and the subsequent exposure. In particular in case the inspection tool is applied to determine a 'global' deformation of the substrate, e.g. due to an applied clamping force, the clamping should preferable not be interrupted, since a clamping process may have a poor reproducibility. Phrased differently, in case a deformation of the substrate would be determined in an inspection tool when the substrate is clamped on a first substrate table, and the substrate is subsequently released and clamped to a second substrate table, the stresses observed when the substrate was clamped on the first substrate table may not be representative for the clamped state of the substrate when clamped on the second substrate table.

In case the inspection tool is incorporated in the lithographic apparatus, it may e.g. be provided in a vacuum chamber of the apparatus, e.g. a dedicated vacuum chamber or a vacuum chamber that is already present, such as in an EUV lithographic apparatus.
In such an arrangement, care should also be taken to ensure the inspection tool, in particular the e-beam source, is not affected by magnetic fields that may be generated by the stage apparatus or other possible sources such as actuators. In order to realize this, an electromagnetic shielding may be applied.

As an alternative to incorporating the inspection tool in the lithographic apparatus, a lithographic system according to the present invention may comprise a lithographic apparatus, an inspection tool according to the invention and a transfer system for transferring a substrate from the inspection tool to the lithographic apparatus. In such embodiment, the transfer system may e.g. transfer the substrate while being clamped onto a substrate table, i.e. both substrate and substrate table are transferred together, in a clamped state, from the inspection tool to the lithographic apparatus.

As another alternative, the inspection tool according to the present invention may be a stand-alone tool having its own substrate table and an interface for transferring substrates to and from the tool.

The inspection tool according to the present invention is configured to detect CL-light emitted by an area of interest, e.g. a portion of a semiconductor substrate. An inspection of a substrate or a portion thereof based on the detection of CL-light may be performed faster than a detection based on back-scattering electrons. Typically, a comparatively large number of photons are generated during the exposure of a substrate with an e-beam, rendering the yield or throughput of this inspection method comparatively high, compared to e.g. the detection of back-scattering electrons. It may however be pointed out that a resolution of a detector detecting back-scattering electrons may be larger than a detector detecting CL-light.

In an embodiment of the present invention, the inspection tool may be provided with different types of detectors, e.g. including a back-scattering (BS) electron detector. In such embodiment, the BS-detector may e.g. be used for calibration purposes. As an example, the BS detector may e.g. be used to calibrate the CL-light detector.

In an embodiment of the present invention, the data obtained from the inspection tool may be combined with data obtained from other tools such as other inspection tools or metrology tools, whereby the combined set of data is used to determine a stress distribution of the area of interest or a deformation of structure on or in the area of interest. Such data as obtained by using the inspection tool according to the present invention or such combined data may further enable to determine a function characteristic or device functionality of the semiconductor device that is manufactured. As an example, the data of the inspection tool according to the present invention may e.g. be combined with data from a SEM (scanning electron microscope) or from OCD (Optical Critical Dimension) metrology, or may be combined with design parameters rather than other measurements. Using this information as feedback to a lithographic apparatus, e.g. to control the exposure process as performed, enables to improve both the device performances and the yield of the apparatus.

The embodiments may further be described using the following clauses:
1. An inspection tool for inspecting a semiconductor substrate, the inspection tool comprising
   - a substrate table configured to hold the substrate;
   - an electron beam source configured to project an electron beam onto an area of interest of the substrate;
   - a cathode-luminesce detector configured to detect cathodoluminescent light emitted from the area of interest;
   - a control unit configured to:
      - receive a signal representative of the detected cathodoluminescent light;
      - determine, based on the signal, a stress distribution of the area of interest.
2. The inspection tool according to clause 1, wherein the control unit is further configured to control the electron beam source to project the electron beam onto the area of interest.
3. The inspection tool according to clause 1 or 2, wherein the control unit is configured to control the electron beam to scan the area of interest.
4. The inspection tool according to any of the preceding clauses, wherein the control unit is further configured to
   - determine, based on the stress distribution, a deformation of the area of interest.
5. The inspection tool according to clause 4, wherein the area of interest comprises a structure and wherein the control unit is configured to:
   - determine a deformation of the structure, based on the stress distribution.
6. The inspection tool according to clause 5, wherein the structure is a portion of a semiconductor device or a mark.
7. The inspection tool according to clause 5, wherein the structure is an alignment mark or an overlay mark.
8. The inspection tool according to any of the clauses 5 to 7, wherein the structure is covered by a layer.
9. The inspection tool according to clause 8, wherein the layer comprises a resist layer.
10. The inspection tool according to any of the clauses 5 to 9, wherein the control unit is configured to determine the deformation of the structure based on a mechanical model of the structure.
11. The inspection tool according to clause 10, wherein the mechanical model comprises a finite element model.
12. The inspection tool according to any of the preceding clauses, wherein the area of interest comprises a plurality of alignment marks, and wherein the control unit is configured to:
   - determine, based on the stress distribution, a deformation of the plurality of alignment marks.
13. The inspection tool according to clause 12, wherein the control unit is further configured to:
   - determine a substrate deformation map, based on the determined deformation of the alignment marks.
14. The inspection tool according to any of the preceding clauses, wherein the control unit is configured to:
   - determine a frequency spectrum of the detected cathodoluminescent light.
15. The inspection tool according to clause 14, wherein the control unit is configured to:
   - determine the stress distribution based on the frequency spectrum.
16. The inspection tool according to any of the preceding clauses, wherein the control unit is configured to determine a frequency spectrum of the detected cathodoluminescent light as a function of position on the area of interest.
17. The inspection tool according to any of the preceding clauses, wherein the control unit is configured to:
   - determine an angular orientation, a polarization or a transient of the detected cathodoluminescent light.
18. The inspection tool according to clause 17, wherein the control unit is configured to:
   - determine the stress distribution based on the angular orientation, the polarization or the transient of the detected cathodoluminescent light.
19. The inspection tool according to any of the preceding clauses, wherein the control unit is configured to:
   - determine, based on the signal, a stress distribution of a volume underneath the area of interest.
20. The inspection tool according to any of the preceding clauses, wherein the detected cathodoluminescent light is generated in an interaction volume underneath the area of interest.
21. The inspection tool according clause 20, wherein the control unit is configured to:
   - determine, based on the signal, a stress distribution in the interaction volume.
22. The inspection tool according to any of the preceding clauses, wherein the control unit comprises an output terminal for outputting a signal representing a deformation of the area of interest.
23. A lithographic apparatus comprising:
   - an illumination system configured to condition a radiation beam;
   - a support constructed to support a patterning device, the patterning device being capable of imparting the radiation beam with a pattern in its cross-section to form a patterned radiation beam;
   - a projection system configured to project the patterned radiation beam onto a target portion of a substrate;
   wherein the apparatus further comprises an inspection tool according to any of the preceding clause and a stage apparatus configured to position the substrate table so as to impart the substrate with the patterned radiation beam.
24. The lithographic apparatus according to clause 23, further comprising a stage control unit configured to control the stage apparatus, the stage control unit configured to receive a deformation signal representative of a deformation of the area of interest, and wherein the control unit is configured to control the stage apparatus based on the deformation signal.
25. The lithographic apparatus according to clause 23 or 24, wherein the substrate table comprises a clamping mechanism for clamping the substrate to the substrate table.
26. The lithographic apparatus according to any of the clauses 23 to 25, further comprising a vacuum chamber configured to enclose the electron beam source.
27. The lithographic apparatus according to clause 26, wherein the vacuum chamber further encloses the projection system.
28. The lithographic apparatus according to any of the clauses 23 to 27, wherein the stage apparatus comprises one or more electromagnetic motors and wherein the lithographic apparatus further comprises a shielding member configured to shield the electron beam source from a magnetic field of the stage apparatus.
29. A lithographic system comprising:
   - a lithographic apparatus comprising:
      - an illumination system configured to condition a radiation beam;
   - a support constructed to support a patterning device, the patterning device being capable of imparting the radiation beam with a pattern in its cross-section to form a patterned radiation beam;
   - a projection system configured to project the patterned radiation beam onto a target portion of a substrate;
      - a stage apparatus configured to position the substrate table so as to impart the substrate with the patterned radiation beam;
   - an inspection tool according to any of the clauses 1 to 22.
30. The lithographic system according to clause 29, further comprising:
   - a transfer system for transferring a substrate from the inspection tool to the lithographic apparatus.
31. The lithographic system according to clause 30, wherein the transfer system is configured to transfer the substrate while the substrate is clamped onto the substrate table.
32. The lithographic system according to clause 31, wherein the transfer system is configured to mount the substrate table with the clamped substrate onto the stage apparatus.
33. An inspection method, the method comprising the steps of:
   - providing a semiconductor substrate with an area of interest, the area of interest comprising a structure;
   - scanning the area of interest using an electron beam;
   - capturing cathodoluminescent light emitted from the area of interest;
   - determining a stress distribution of the area of interest.
34. The inspection method according to clause 33, further comprising:
   - determining a deformation of the structure, based on the stress distribution.
35. The inspection method according to clause 34, wherein the structure comprises an alignment mark or an overlay mark.
36. The inspection method according to clause 35, wherein the area of interest comprises a plurality of alignment marks, further comprising:
   - determining a deformation of the plurality of alignment marks and
   - determining a substrate deformation map based on the determined deformation of the plurality of alignment marks.
37. A device manufacturing method comprising projecting a patterned beam of radiation onto a substrate, wherein the step of projecting the patterned beam of radiation onto the substrate is preceded by the inspection method according to any of the clauses 33 to 36.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. An inspection tool for inspecting a semiconductor substrate, the inspection tool comprising
- a substrate table configured to hold the substrate;
- an electron beam source configured to project an electron beam onto an area of interest of the substrate;
- a cathode-luminesce detector configured to detect cathodoluminescent light emitted from the area of interest;
- a control unit configured to:
- receive a signal representative of the detected cathodoluminescent light;
- determine, based on the signal, a stress distribution of the area of interest.

2. The inspection tool according to claim 1, wherein the control unit is further configured to control the electron beam source to project the electron beam onto the area of interest.

3. The inspection tool according to claim 1 or 2, wherein the control unit is configured to control the electron beam to scan the area of interest.

4. The inspection tool according to any of the preceding claims, wherein the control unit is further configured to
- determine, based on the stress distribution, a deformation of the area of interest.

5. The inspection tool according to claim 4, wherein the area of interest comprises a structure and wherein the control unit is configured to:
- determine a deformation of the structure, based on the stress distribution.

6. The inspection tool according to claim 5, wherein the structure is a portion of a semiconductor device or a mark.

7. The inspection tool according to any of the claims 5 to 6, wherein the structure is covered by a layer.

8. The inspection tool according to claim 7, wherein the layer comprises a resist layer.

9. The inspection tool according to any of the claims 5 to 8, wherein the control unit is configured to determine the deformation of the structure based on a mechanical model of the structure.

10. The inspection tool according to claim 9, wherein the mechanical model comprises a finite element model.

11. The inspection tool according to any of the preceding claims, wherein the area of interest comprises a plurality of alignment marks, and wherein the control unit is configured to:
- determine, based on the stress distribution, a deformation of the plurality of alignment marks.

12. The inspection tool according to any of the preceding claims, wherein the control unit is configured to:
- determine a frequency spectrum of the detected cathodoluminescent light.

13. The inspection tool according to claim 12, wherein the control unit is configured to:
- determine the stress distribution based on the frequency spectrum.

14. The inspection tool according to any of the preceding claims, wherein the control unit is configured to determine a frequency spectrum of the detected cathodoluminescent light as a function of position on the area of interest.

15. The inspection tool according to any of the preceding claims, wherein the detected cathodoluminescent light is generated in an interaction volume underneath the area of interest.
